# EUROPEAN PATENT SPECIFICATION

(11) **EP 0 265 271 B1**
(45) Date of publication and mention of the grant of the patent: **17.04.1996**
(21) Application number: 87309365.2
(22) Date of filing: 22.10.1987
(51) Int. Cl.: H01L 27/14, H04N 3/15

(54) **Electronic shutter for an electronic camera and method of utilizing a CCD image sensor as electronic shutter for such a camera**
Elektronischer Verschluss für eine elektronische Kamera und Verfahren zur Verwendung eines CCD Bildsensors als elektronischer Verschluss für eine solche Kamera
Obturateur électronique pour une caméra électronique et méthode pour utiliser un capteur d'image CCD comme obturateur électronique pour une telle caméra

(30) Priority: 23.10.1986 JP 252375/86; 23.12.1986 JP 307474/86
(43) Date of publication of application: 27.04.1988
(60) Divisional application: 95202218.4
(73) Proprietor: SONY CORPORATION, Tokyo 141 (JP)
(72) Inventor: Yonemoto, Kazuya c/o Patent Division, Shinagawa-ku Tokyo 141 (JP); Kagawa, Yoshiaki c/o Patent Division, Shinagawa-ku Tokyo 141 (JP); Ishikawa, Kikue c/o Patent Division, Shinagawa-ku Tokyo 141 (JP); Suzuki, Tomoyuki c/o Patent Division, Shinagawa-ku Tokyo 141 (JP); Hamasaki, Masaharu c/o Patent Division, Shinagawa-ku Tokyo 141 (JP)
(74) Representative: Cotter, Ivan John

(56) References cited:
- EP-A- 0 173 542
- DE-A- 3 326 924
- DE-A- 3 514 994
- PATENT ABSTRACTS OF JAPAN, vol. 8, no. 63 (E-233), 24th March 1984;& JP-A-58 212 167 & US-A-4696 021
- PATENT ABSTRACTS OF JAPAN, vol. 8, no. 131 (E-251), 19th June 1984;& JP-A-59 040 779 & US-A-4696 021

## Description

This invention relates to electronic shutters for charged coupled device (CCD) image sensors, and to methods of utilizing a CCD image sensor as an electronic shutter, for example, for an electronic camera such as a video camera or an electronic still camera.

It has been required that a solid state imager device be able to control its exposure time by electronic means provided therein, so that when the imager device is used in, for example, a video camera, the use of a mechanical shutter as hitherto proposed, is unnecessary. Without a mechanical shutter, a video camera could be made smaller, lighter, and cheaper.

There has already been proposed a solid state imager device which permits selection between two exposure times, one long and one short. This imager device has one of the two exposure times chosen to be 1/30 second, which is equal to one frame period in the NTSC television system, and the other exposure time chosen to be about 1/2000 second, which is equal to a vertical blanking period.

In this imager device, when the 1/30 second exposure time is selected, signal charges accumulated in the light receiving section during one frame period are read out as an image signal. On the other hand, when the 1/2000 second exposure time is selected, signal charges accumulated before a vertical blanking period are read out to a vertical register section and discharged by a high speed transfer, while signal charges newly accumulated only during the vertical blanking period are read out as an image signal.

However, this imager device is limited in that it only allows selection between two exposure times so that, even when a video camera is equipped with such an imager device, it still requires a mechanical shutter. Moreover, since a high speed transfer is required to discharge the signal charges accumulated before a vertical blanking period to the vertical register, the imager device consumes excessive electric power.

German patent specification DE-A1-3 326 924 (US-A-4 717 945) discloses a solid state image device, with an electronic shutter function, and corresponding to the pre-characterizing part of claim 1. However, with that device the contrast of the reproduced image fluctuates.

According to the present invention there is provided an electronic shutter for an electronic camera, the shutter comprising: a CCD image sensor having a semiconductor substrate of a first conductivity type; a region of a second conductivity type formed on said substrate; a signal charge accumulating region formed on a surface side of said second conductivity type region; and means for applying a predetermined voltage to said substrate thereby to discharge signal charges accumulated in said signal charge accumulating region to said substrate; characterised in that:
said means for applying said predetermined voltage comprises a switching circuit (18) connected to said semiconductor substrate (1) and is arranged to apply, in-between vertical retraces of said image sensor, said predetermined voltage to said substrate only during horizontal blanking periods of said image sensor.

According to the present invention there is also provided a method of utilizing a CCD image sensor as an electronic shutter for an electronic camera, comprising the step of applying a predetermined voltage to a semiconductor substrate of a first conductivity type having a region of a second conductivity type formed thereon, thereby to discharge signal charges accumulated in a signal charge accumulating region formed on a surface side of said second conductivity type region to said substrate; characterised in that:
in-between vertical retraces of said image sensor, said predetermined voltage is only applied to said semiconductor substrate during horizontal blanking periods of said image sensor.

The invention will now be described by way of example with reference to the accompanying drawings, in which:
Figure 1 is a cross-sectional view showing an embodiment of solid state imager device according to the present invention;
Figure 2 is a graph showing potentials of respective regions of the imager device of Figure 1 in the depth direction thereof;
Figures 3A and 3B are timing charts of a general explanatory nature which assist in understanding a shutter function of the imager device; and
Figures 4A to 4E are timing charts for explaining a shutter function embodying the invention.

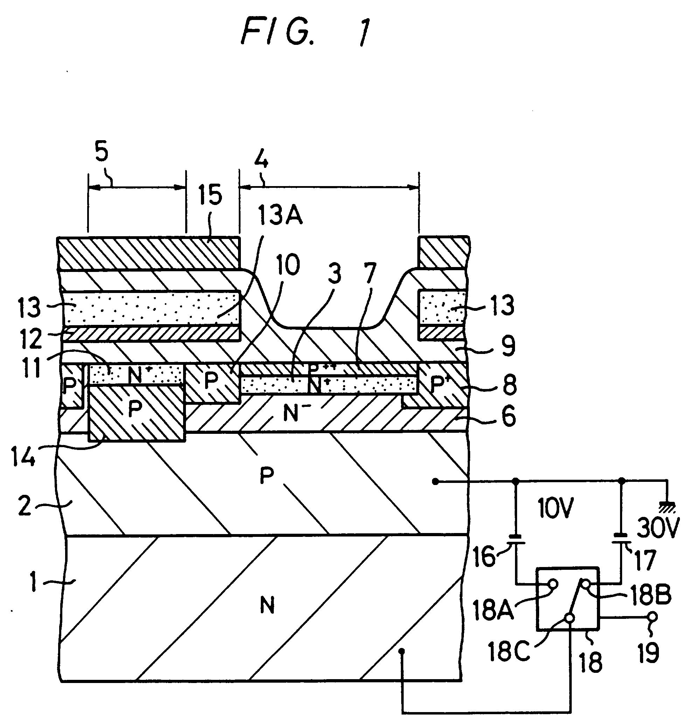

The solid state image device of Figure 1 comprises an N type silicon substrate 1 upon which a light receiving section 4, a vertical register section 5, a horizontal register section (not shown) and an output section (not shown) are formed, so as to constitute a so-called interline transfer charge coupled device (CCD) type imager device. On the surface of the substrate 1 there is deposited, for example, by epitaxial growth techniques, a P type region 2. An N⁻ type region 6 is deposited on the surface of the P type region 2.

The light receiving section 4 is formed of a shallow P⁺⁺ type region 7 formed in a surface region of the N⁻ type region 6 and an N⁺ type region 3 is formed beneath the P⁺⁺ type region 7 to constitute a signal charge accumulating region. There is also a P⁺ type region 8 constituting a channel stopper section formed adjacent to the P⁺⁺ type region 7 and the N⁺ type region 3. An insulating layer 9 made of SiO₂ is deposited on the P⁺⁺ type region 7.

The vertical register section 5 is formed such that an N⁺ type region 11, which constitutes a signal charge transfer region, is formed adjacent to a P type region 10, which constitutes a read-out gate region. A transfer electrode 13 made of polysilicon and another insulating layer 12 made of Si₃N₄ are formed above the N⁺ type region 11 within the SiO₂ insulating layer 9. One end portion of the transfer electrode 13 is also used as a read-out gate electrode 13A. A P type region 14 is formed, for preventing smear, beneath the N⁺ type region 11. An aluminium layer 15 for shielding light is deposited above the transfer electrode 13 above the insulating layer 9.

Although only two of the transfer electrodes 13 are illustrated in Figure 1, there are disposed a predetermined number of transfer electrodes 13 such that the vertical register section 5 is driven in known manner by a four-phase drive. The horizontal register section and the output section which are not illustrated in the drawing, are of known form.

In the embodiment of Figure 1, the negative voltage terminals of direct current (DC) power supply sources 16 and 17 are commonly connected to the P type region 2 and earthed. The positive voltage terminals of the sources 16 and 17 are connected to first and second fixed contacts 18A and 18B, respectively, of a switching circuit 18. A movable contact 18C of the switching circuit 18 is connected to the substrate 1.

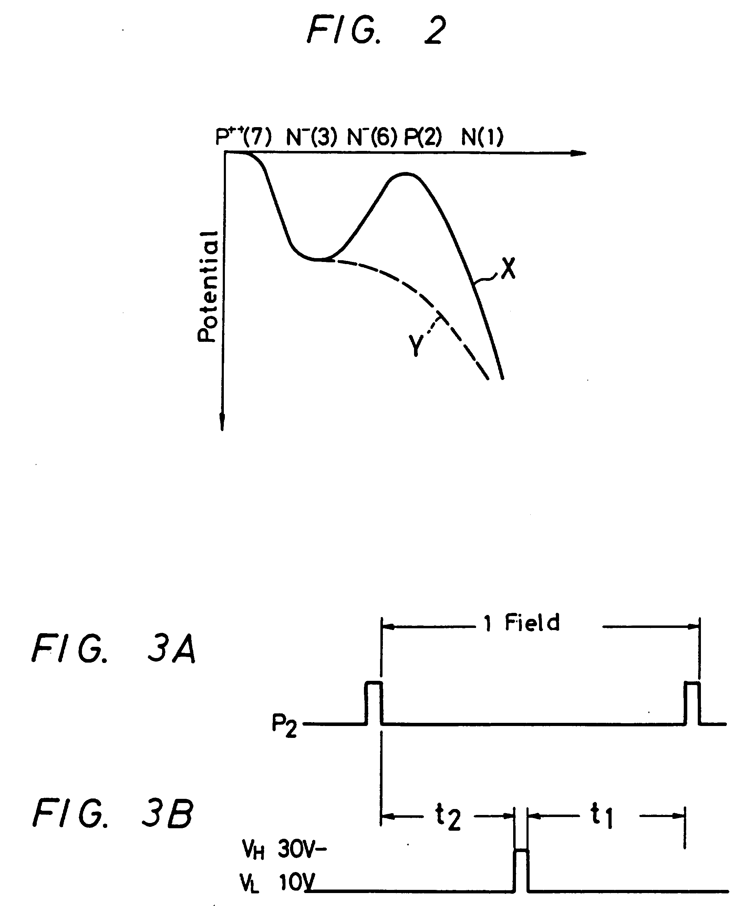

An output voltage V_{L} from the source 16 is selected to be a value, for example, 10 volts, such that when the voltage V_{L} is applied to the substrate 1, the potential in the P type region 2 becomes slightly lower than the potential of the shallow P⁺⁺ type region 7 on the surface of the N⁺ type region 3, as shown by a solid line X in Figure 2, so that signal charges can be accumulated in the N⁺ type signal charge accumulating region 3 and blooming can be effectively suppressed. An output voltage V_{H} from the source 17 is selected to be a value, for example 30 volts, such that when the voltage V_{H} is applied to the substrate 1, the potential in the P type region 2 becomes lower than the potential in the signal charge accumulating region 3, as is shown by a broken line Y in Figure 2, so that the signal charges accumulated in the signal charge accumulating region 3 can be discharged to the substrate 1. Switching of the switching circuit 18 can be controlled by a control signal supplied thereto through a control signal input terminal 19.

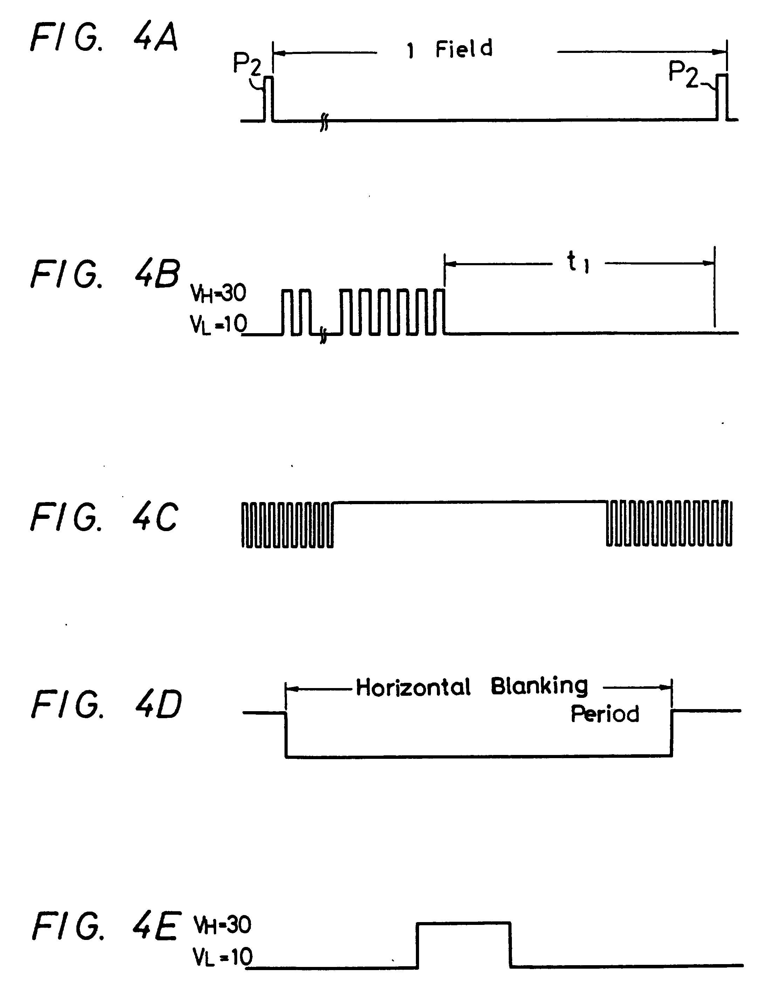

Figures 3A and 3B are diagrams of a general explanatory nature which assist in understanding the operation of the imager device of Figure 1 which will be described hereinafter with reference to Figures 4A to 4E. When a read-out pulse P₂, as shown in Figure 3A, is supplied to the read-out gate electrode 13A while the output voltage V_{L} from the source 16 is applied to the substrate 1, signal charges accumulated in the signal charge accumulating region 3 are read out to the vertical register section 5. Therefore, in the embodiment of Figure 1, the read-out pulse P₂ is supplied to the read-out gate electrode 13A at every field within the vertical retrace.

After the rad-out pulse P₂ has been supplied to the read-out gate electrode 13A, if the switching circuit 18 is controlled so as to supply the substrate 1 with the 30 volts pulse, that is supplying a discharging pulse P₁ at a desired time within one field period as shown in Figure 3B, signal charges accumulated in the signal charge accumulating region 3 for a period t₂, that is a period from the time the proceeding read-out pulse P₂ is applied to the read-out gate electrode 13A to the time the current discharging pulse P₁ is applied to the substrate 1, are transferred to the substrate 1. Therefore, when the next read-out pulse P₂ is supplied to the read-out gate electrode 13A, signal charges accumulated in the signal charge accumulating region 3 for the period t₁, that is a period from the supply of the present read-out pulse P₂, are read out to the vertical register section 5.

With reference now to Figures 1 and 4A to 4E, the method of controlling the exposure time of the imager device embodying the invention will be explained in detail.

After signal charges accumulated in the signal charge accumulating region 3 for the preceding field period have been read out by the read-out pulse P₂ shown in Figure 4A (the same as that shown in Figure 3A) to the vertical register section 5, the voltage V_{H} (30 volts) is applied from the source 16 through the switching circuit 18 to the substrate 1 so as to discharge the signal charges accumulated in the signal charge accumulating region 3 in such a manner that an arbitrary number of the horizontal blanking periods, each being set at 63.5 microseconds, are successively selected. During the horizontal blanking periods thus selected, the switching circuit 18 is controlled by the control signal applied thereto from the terminal 19 so that the movable contact 18C engages the second fixed contact 18B. In other words, after the signal charges have been read out by the read-out pulse P₂, the voltage V_{H} (30 volts) is applied to the substrate 1 at every horizontal blanking period to discharge the signal charges accumulated in the signal charge accumulating region 3 until immediately before the exposure is started. During the exposure time period t₁ (Figure 4B), the voltage V_{L} (10 volts) is applied from the source 16 through the switching circuit 18 to the substrate 1 to accumulate signal charges in the signal charge accumulating region 3. Figure 4C shows a horizontal clock signal while Figure 4D shows a horizontal blanking signal, and Figure 4E shows the voltages to be applied to the substrate 1 within the horizontal blanking period.

As described above, the exposure time of the imager device becomes the period t₁, so that a desired exposure time can be obtained. Accordingly, when this imager device is used in a video camera, it does not have to be provided with a mechanical shutter, so that it is possible to reduce the size, weight and manufacturing cost of the camera.

The exposure time t₁ can be changed in a range between 1/60 and 1/10000 of a second by selecting the number of horizontal blanking periods for discharging the signal charges accumulated in the signal charge accumulating region 3, as shown in Figure 4B.

Furthermore, for discharging the signal charges, the imager device does not have to operate the vertical register section 5 at a high speed as do the previously proposed solid state imager devices. The present imager device only requires, for example, pulses of 30 volts to be applied to the substrate 1, so that the electric power necessary for the exposure control can be substantially reduced.

As described above, the exposure time is controlled by changing the voltage applied to the substrate 1. Since the voltage V_{H} is applied to the substrate 1 within the horizontal blanking period, even although a buffer amplifier and other devices forming the output section are caused to fluctuate by changing the voltage applied to the substrate 1, the reproduced image will not be influenced by the above change, so that it is possible to obtain reproduced images with a constant contrast.

The above description relates to where the signal charges are discharged at every horizontal blanking period until immediately before the exposure is started. Modifications can be made dependent on the characteristics of a solid state imager device, such as where the signal charges are discharged only once within the horizontal blanking period immediately before the exposure is started, or where some of the horizontal blanking periods before the exposure is started are selected to discharge the signal charges. In other words, the number of discharges can be selected in accordance with the characteristics of each solid state imager device.

## Claims

1. An electronic shutter for an electronic camera, the shutter comprising:
a CCD image sensor having a semiconductor substrate (1) of a first conductivity type;
a region (2) of a second conductivity type formed on said substrate (1);
a signal charge accumulating region (3) formed on a surface side of said second conductivity type region; and
means (16 to 19) for applying a predetermined voltage to said substrate (1) thereby to discharge signal charges accumulated in said signal charge accumulating region (3) to said substrate (1);
characterised in that:
said means (16 to 19) for applying said predetermined voltage comprises a switching circuit (18) connected to said semiconductor substrate (1) and is arranged to apply, in-between vertical retraces of said image sensor, said predetermined voltage to said substrate (1) only during horizontal blanking periods of said image sensor.

2. A method of utilizing a CCD image sensor as an electronic shutter for an electronic camera, comprising the step of applying a predetermined voltage to a semiconductor substrate (1) of a first conductivity type having a region (2) of a second conductivity type formed thereon, thereby to discharge signal charges accumulated in a signal charge accumulating region (3) formed on a surface side of said second conductivity type region (2) to said substrate (1);
characterised in that:
in-between vertical retraces of said image sensor, said predetermined voltage is only applied to said semiconductor substrate (1) during horizontal blanking periods of said image sensor.

## Patentansprüche

1. Elektronischer Verschluß für eine elektronische Kamera, wobei der Verschluß aufweist:
einen CCD-Bildsensor, der ein Halbleitersubstrat (1) einer ersten Leitfähigkeit hat;
einen Bereich (2) einer zweiten Leitfähigkeit, der auf dem Substrat (1) gebildet ist;
einen Signalladungs-Sammelbereich (3), der auf einer Oberflächenseite des zweiten Leitfähigkeitsbereichs gebildet ist; und
eine Einrichtung (16 bis 19) zum Anlegen einer vorgegebenen Spannung an das Substrat (1), um dadurch Signalladungen, die sich im Signalladungs-Sammelbereich (3) angesammelt haben, zum Substrat (1) zu entladen;
dadurch gekennzeichnet,
daß die Einrichtung (16 bis 19) zum Anlegen der vorgegebenen Spannung eine Schaltschaltung (18) besitzt, die mit dem Halbleitersubstrat (1) verbunden ist, und eingerichtet ist - zwischen vertikalen Rückläufen des Bildsensors - die vorgegebene Spannung an das Substrat (1) nur während horizontaler Austastperioden des Bildsensors anzulegen.

2. Verfahren zur Verwendung eines CCD-Bildsensors als elektronischen Verschluß für eine elektronische Kamera, das den Schritt eines Anlegens einer vorgegebenen Spannung an ein Halbleitersubstrat (1) einer ersten Leitfähigkeit umfaßt, das einen Bereich (2) einer zweiten Leitfähigkeit hat, der darauf gebildet ist, um dadurch Signalladungen, die sich in einem Signalladungs-Sammelbereich (3), der auf einer Oberflächenseite des zweiten Leitfähigkeitsbereichs (2) auf dem Substrat (1) gebildet ist, angesammelt haben, zum Substrat (1) zu entladen;
dadurch gekennzeichnet, daß
zwischen vertikalen Rückläufen des Bildsensors die vorgegebene Spannung an das Halbleitersubstrat (1) nur während horizontaler Austastperioden des Bildsensors angelegt wird.

## Revendications

1. Obturateur électronique pour une caméra électronique, l'obturateur comprenant:
- un capteur d'images à CCD ayant un substrat de semiconducteur (1) d'un premier type de conductibilité;
- une région (2) d'un deuxième type de conductibilité formé sur ledit substrat (1);
- une région accumulant des charges formant signal (3) formée sur un côté superficiel de ladite région d'un deuxième type de conductibilité; et
- des moyens (16 à 19) pour appliquer une tension prédéterminée audit substrat (1) pour décharger par ce moyen les charges formant signal accumulées dans ladite région accumulant des charges formant signal (3) audit substrat (1),
caractérisé en ce que:
- lesdits moyens (16 à 19) pour appliquer ladite tension prédéterminée comprennent un circuit de commutation (18) connecté audit substrat de semiconducteur (1) et sont agencés pour appliquer, entre les retours de balayage vertical dudit capteur d'images, ladite tension prédéterminée audit substrat (1) uniquement pendant les périodes de suppresson horizontale dudit capteur d'images.

2. Procédé pour utiliser un capteur d'images à CCD comme oburateur électronique pour une caméra électronique, comprenant l'étape consistant à appliquer une tension prédéterminée à un substrat de semiconducteur (1) d'un premier type de conductibilité ayant une région (2) d'un deuxième type de conductibilité formée sur celui-ci, pour décharger par ce moyen des charges formant signal accumulées dans une région accumulant des charges formant signal (3) formée sur un côté superficiel de ladite région d'un deuxième type de conductibilité (2) audit substrat (1),
caractérisé en ce que:
- entre les retours de balayage vertical, ladite tension prédéterminée n'est appliquée audit substrat de semiconducteur (1) que pendant les périodes de suppression horizontale dudit capteur d'images.
